Europäisches Patentamt

(19) European Patent Office

Office européen des brevets

(11) Numéro de publication : **0 459 908 A1**

# (12) DEMANDE DE BREVET EUROPEEN

(21) Numéro de dépôt : **91401410.5**

(51) Int. Cl.⁵ : **H01R 17/12, G01R 1/06**

(22) Date de dépôt : **30.05.91**

(30) Priorité : 30.05.90 FR 9006722

(43) Date de publication de la demande :
04.12.91 Bulletin 91/49

(84) Etats contractants désignés :
DE GB IT NL

(71) Demandeur : RADIALL Société anonyme dite:
101, rue Philibert Hoffmann
F-93116 Rosny sous Bois (FR)

(72) Inventeur : Cartier, Jacques Georges
8, avenue Foch
F-94120 Fontenay sous Bois (FR)

(74) Mandataire : Leszczynski, André et al
CABINET NONY & CIE. 29 rue Cambacérès
F-75008 Paris (FR)

(54) Connecteur pour câble coaxial.

(57)    L'invention est relative à un connecteur pour relier de manière séparable un câble coaxial à un couple de tiges conductrices espacées, parallèles, notamment de tiges de contact sortant d'un circuit intégré.

Il comprend un corps tubulaire conducteur (13) apte à être fixé au conducteur extérieur (14) du câble coaxial (1), à l'extrémité de celui-ci, et muni intérieurement de moyens (15) pour raccorder, de manière séparable, le conducteur central (16) du câble coaxial à l'une des tiges (7), ledit corps tubulaire comportant, au voisinage de l'extrémité du câble coaxial, une patte tubulaire conductrice (18) d'axe parallèle à l'axe du corps tubulaire, et en contact avec le conducteur extérieur du câble coaxial, ladite patte étant agencée pour recevoir de manière amovible des moyens de contact (21,22,23) aptes à assurer un contact électrique avec la seconde tige (8) et ladite patte tubulaire (18).

EP 0 459 908 A1

Jouve, 18, rue Saint-Denis, 75001 PARIS

La présente invention est relative à un connecteur destiné à être monté à l'extrémité d'un câble coaxial pour relier de manière séparable ledit câble coaxial à un couple de tiges conductrices espacées, parallèles, notamment de tiges de contact sortant d'un circuit intégré.

Le connecteur selon la présente invention est, dans une application particulière, destiné à relier un câble coaxial d'entrée d'un appareil de mesure hyperfréquence pour mesurer et contrôler les caractéristiques d'un circuit intégré micro-ondes encapsulé dans un boîtier hermétique. Dans ce cas, les tiges sont des axes traversant hermétiquement une platine métallique sur laquelle est monté le circuit intégré et qui est solidaire du boîtier hermétique d'encapsulation, l'une des tiges étant reliée à une piste active du circuit intégré recevant le signal d'un composant actif micro-ondes du circuit intégré, l'autre tige étant reliée à une piste de masse dudit circuit intégré.

Les circuits intégrés micro-ondes avec leurs composants actifs sont dans la pratique encapsulés dans des boîtiers hermétiques fermés par une platine métallique comportant des traversées hermétiques dont le nombre correspond au nombre de tiges conductrices du circuit intégré devant sortir du boîtier.

La traversée hermétique de la platine métallique s'effectue par l'intermédiaire d'une perle de verre scellant la tige correspondante dans l'orifice traversant ménagé dans la platine pour le passage de la tige.

Le boîtier hermétique contenant le circuit intégré micro-ondes peut alors être monté sur une carte de circuit imprimé comportant des trous et des pistes métallisées pour y souder les tiges ou axes sortant du circuit intégré encapsulé comme pour tout autre composant devant être monté sur la carte de circuit imprimé.

Avant d'installer définitivement le circuit intégré micro-ondes encapsulé dans son boîtier sur la carte de circuit imprimé, il est nécessaire de mesurer et contrôler les caractéristiques hyperfréquences du circuit et notamment les caractéristiques de chacun de ses composants actifs micro-ondes.

Les circuits utilisés actuellement fonctionnent jusqu'à des fréquences de quelques GHz, par exemple trois GHz, et, pour la mesure des caractéristiques de chaque composant actif, il est nécessaire de le raccorder à un câble coaxial relié à l'appareil de mesure par l'intermédiaire d'un couple de tiges reliées à la piste active du composant actif micro-ondes et respectivement à la piste de masse.

L'invention propose un connecteur à cet effet qui comprend un corps tubulaire conducteur apte à être fixé au conducteur extérieur du câble coaxial à l'extrémité de celui-ci et muni intérieurement de moyens pour raccorder de manière séparable le conducteur central dudit câble coaxial à l'une des tiges, à savoir la tige de piste active dans l'application considérée, ledit corps tubulaire comportant, au voisinage de l'extrémité du câble coaxial, une patte tubulaire conductrice, d'axe parallèle à l'axe du corps tubulaire, et en contact avec le conducteur extérieur du câble coaxial, ladite patte étant agencée pour recevoir de manière amovible des moyens de contact aptes à assurer un contact électrique entre la seconde tige, à savoir la tige de piste de masse dans l'application considérée, et ladite patte tubulaire.

Dans un mode de réalisation particulier, il est prévu à cet effet une pièce de contact tubulaire munie, à une extrémité, de moyens de fixation aptes à coopérer avec des moyens de fixation complémentaires réalisés à l'intérieur de la patte tubulaire, et, à son autre extrémité, de moyens de contact notamment élastiques avec la tige correspondante.

Dans un mode de réalisation préféré, la pièce de contact est fixée de manière amovible à l'intérieur de la patte annulaire par vissage.

Dans un mode de réalisation avantageux de l'invention le corps cylindrique du connecteur muni des moyens de contact de la première tige (tige de piste active), et les moyens de contact de la seconde tige (tige de piste de masse) sont mis en place dans des trous cylindriques respectifs traversants parallèles d'un socle sur lequel ils sont immobilisés par des moyens de retenue, tels que des parties en décrochement venant en appui sur des faces opposées du socle.

Dans la mesure où, comme expliqué précédemment, on peut être amené à mesurer, à chaque fois par un câble coaxial, les caractéristiques de l'un de plusieurs composants actifs micro-ondes d'un circuit intégré, on peut, selon une caractéristique particulière de l'invention, prévoir un socle comportant une pluralité de paires de trous cylindriques traversants formés selon une disposition correspondant à celle des couples de tiges, de piste active et respectivement de piste de masse, dont la connexion à un câble coaxial relié à un appareil de mesure hyperfréquence doit être réalisée.

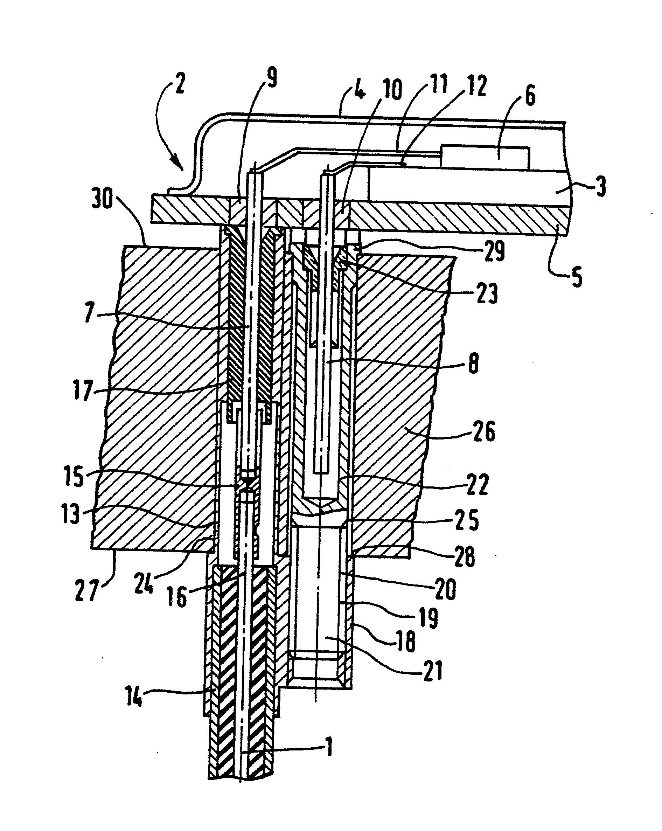

Dans le but de mieux faire comprendre l'invention on va maintenant en décrire à titre d'exemple nullement limitatif un mode de réalisation en se référant au dessin annexé dans lequel :

– la figure unique est une vue en coupe d'un connecteur selon l'invention.

On a illustré sur le dessin un connecteur selon l'invention pour réaliser une liaison par l'intermédiaire d'un câble coaxial 1 entre un composant électronique à tester désigné globalement par 2 et un appareil de mesure non représenté.

Dans l'exemple illustré, le composant électronique est un circuit intégré micro-ondes 3 encapsulé dans un boîtier hermétique 4 comportant une platine métallique 5, les opérations de mesure et de contrôle devant porter sur les caractéristiques hyperfréquences d'un composant actif micro-ondes 6 du circuit intégré.

Des tiges de contact parallèles, espacées, 7 et 8, sortent de la platine 5 au travers d'orifices scellés par des perles de verre 9 et respectivement 10, la tige 7 étant solidaire à son extrémité d'une piste active 11 du circuit intégré correspondant au composant actif 6 et la tige 8 étant reliée à la piste de masse 12 dudit circuit intégré.

Le connecteur selon l'invention comprend un corps tubulaire conducteur 13 apte à être fixé, notamment par soudure, sur le conducteur extérieur 14 du câble coaxial 1, le corps 13 comportant intérieurement un contact central 15 en forme de douille double, fixé. par un côté, notamment par soudure, à l'âme centrale conductrice 16 du câble coaxial et comportant à son extrémité opposée un contact élastique destiné à s'engager sur la tige 7. Le corps 13 comporte en outre un isolant tubulaire 17 s'étendant sur une partie de sa longueur à partir de l'extrémité du corps 13 au niveau de la platine 5.

Au voisinage de sa partie en contact avec le câble coaxial 1, le corps 13 comporte une patte tubulaire conductrice 18 réalisée de préférence d'un seul tenant avec lui et comportant un taraudage 19 dans lequel vient se visser par un filetage correspondant 20 une partie d'extrémité cylindrique 21 d'une pièce tubulaire 22 qui est munie au voisinage de son autre extrémité d'un contact élastique 23 pour assurer une continuité électrique entre la tige 8 autour de laquelle la pièce 22 et le contact 23 sont engagés et la patte conductrice 18 et donc le conducteur extérieur 14 du câble coaxial 1.

Dans l'exemple illustré, le corps 13 pourvu de la patte 18 et fixé au câble coaxial, et la pièce 22 sont chacun logés dans l'un d'une paire de trous cylindriques 24,25 traversant un socle 26.

Le corps 13 monté à l'extrémité du câble coaxial est introduit, de bas en haut sur le dessin, dans le trou correspondant 24 du socle 26 et vient en appui sur une face d'extrémité 27 du socle par une portée en décrochement 28 de la patte 18.

La pièce 22 est introduite dans le socle par l'autre côté du socle dans le second trou 25 et est solidarisée du corps 13 par vissage de sa partie d' extrémité cylindrique 21 dans la patte 18.

A son extrémité opposée à la partie 21, la pièce 22 comporte une collerette en décrochement 29 par laquelle elle vient en appui sur la face 30 du socle opposée à la face 27.

On peut alors connecter simultanément les tiges 7 et 8 d'un composant électronique à un ensemble unitaire ainsi formé par enfichage du composant du haut vers le bas sur le dessin.

Bien que l'invention ait été décrite en liaison avec un mode de réalisation particulier, il est bien évident qu'elle n'y est nullement limitée et qu'on peut lui apporter de nombreuses variantes et modifications sans pour autant sortir ni de son cadre ni de son esprit.

## Revendications

1. Connecteur pour relier de manière séparable un câble coaxial à un couple de tiges conductrices espacées, parallèles, notamment de tiges de contact sortant d'un circuit intégré, caractérisé par le fait qu'il comprend un corps tubulaire conducteur (13) apte à être fixé au conducteur extérieur (14) du câble coaxial (1), à l'extrémité de celui-ci, et muni intérieurement de moyens (15) pour raccorder, de manière séparable, le conducteur central (16) du câble coaxial à l'une des tiges (7), ledit corps tubulaire comportant, au voisinage de l'extrémité du câble coaxial, une patte tubulaire conductrice (18) d'axe parallèle à l'axe du corps tubulaire, et en contact avec le conducteur extérieur du câble coaxial, ladite patte étant agencée pour recevoir de manière amovible des moyens de contact (21,22,23) aptes à assurer un contact électrique avec la seconde tige (8) et ladite patte tubulaire (18).

2. Connecteur selon la revendication 1, caractérisé par le fait que lesdits moyens de contact (21,22,23) comportent une pièce de contact tubulaire (22) munie à une extrémité de moyens de fixation (20,21) aptes à coopérer avec des moyens de fixation complémentaires (19) réalisés à l'intérieur de la patte tubulaire (18) et, à son autre extrémité, de moyens de contact, notamment élastiques, (23) avec la tige correspondante (8).

3. Connecteur selon la revendication 2, caractérisé par le fait que la pièce de contact (22) est fixée de manière amovible à l'intérieur de la patte annulaire (18) par vissage (19,20).

4. Connecteur selon l'une quelconque des revendications précédentes, caractérisé par le fait que le corps cylindrique du connecteur muni des moyens de contact de la première tige d'une part, et les moyens de contact (21,22,23) de la seconde tige d'autre part, sont mis en place dans des trous cylindriques traversants parallèles respectifs (24,25) d'un socle (26) sur lequel ils sont immobilisés par des moyens de retenue tels que des parties en décrochement (28,29) venant en appui sur des faces opposées (27,30) du socle.

5. Connecteur selon l'une quelconque des revendications précédentes, caractérisé par le fait qu'il comprend un socle (26) comprenant une pluralité de paires de trous parallèles traversants formés selon une disposition correspondant à celle d'une pluralité de couples de tiges.

6. Utilisation du connecteur selon l'une quelconque des revendications précédentes, pour relier un câble coaxial d'entrée d'un appareil de mesure hyperfréquence pour mesurer et contrôler les caractéristiques d'un circuit intégré micro-ondes (3) encapsulé dans un boîtier hermétique (4,5), lesdites tiges (7 et 8) étant respectivement reliées à une piste active (11) du circuit intégré recevant le signal d'un composant actif micro-ondes (6) de celui-ci, la seconde tige (8) étant reliée à une piste de masse (12) dudit circuit intégré (3).

Office européen
des brevets

**RAPPORT DE RECHERCHE EUROPEENNE**

Numero de la demande

EP   91 40 1410

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| Y | EP-A-341535 (STANDARD ELEKTRIK LORENZ) <br> * colonne 2, lignes 10 - 21 * | 1, 4-5 | H01R17/12 <br> G01R1/06 |
| A | * colonne 3, lignes 5 - 19; figure 3 * | 6 | |
| Y | FR-A-2192395 (RAYCHEM) <br> * page 2, lignes 37 - 39 * | 1, 4-5 | |
| A | * figure 4 * | 6 | |
| A | ELECTRONICS TEST. <br> vol. 11, no. 6, juin 1988, SAN FRANCISCO US <br> pages 76 - 82; Emory Harry: <br> "Automated Probing of High-Speed Analog/Mixed Boards" <br> * page 76, colonne du milieu, alinéa 1; figure 5 * | 6 | |
| A | WO-A-8605035 (MINNESOTA MINING AND MANUFACTURING COMPANY) <br> * page 13, alinéa 1; figure 3 * | 1 | |

**DOMAINES TECHNIQUES RECHERCHES (Int. Cl.5)**

G01R
H01R

Le présent rapport a été établi pour toutes les revendications

| Lieu de la recherche | Date d'achèvement de la recherche | Examinateur |
|---|---|---|
| LA HAYE | 11 SEPTEMBRE 1991 | SIBILLA S. |

EPO FORM 1503 03.82 (P0403)

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant